(19) Europäisches Patentamt
European Patent Office
Office européen des brevets

(11) **EP 4 212 898 A1**

(12) **EUROPEAN PATENT APPLICATION**

(43) Date of publication:
**19.07.2023 Bulletin 2023/29**

(21) Application number: **22151713.9**

(22) Date of filing: **17.01.2022**

(51) International Patent Classification (IPC):
*G01R 33/30* (2006.01)   *G01R 33/60* (2006.01)
*G21K 1/00* (2006.01)   *G01R 33/38* (2006.01)
*G01R 33/3815* (2006.01)   *H01F 6/00* (2006.01)
*H01F 6/04* (2006.01)

(52) Cooperative Patent Classification (CPC):
**G01R 33/307; G01R 33/3804; G01R 33/3815;
G01R 33/60; H01F 6/00; H01F 6/04**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **ETH Zurich
8092 Zürich (CH)**

(72) Inventor: **The designation of the inventor has not
yet been filed**

(74) Representative: **Detken, Andreas
Isler & Pedrazzini AG
Giesshübelstrasse 45
Postfach 1772
8027 Zürich (CH)**

(54) **MAGNETIC RESONANCE DEVICE COMPRISING A SAMPLE SPINNING APPARATUS WITH AN ELECTROMAGNETIC FIELD FOR SPINNING THE SAMPLE**

(57)    A magnetic resonance device comprises a sample spinning apparatus (20) configured to spin a sample (30) about a sample spinning axis (R), the sample spinning apparatus being configured to exert a torque on the sample by interaction of the sample with an electromagnetic sample spinning field.

FIG. 1

## Description

TECHNICAL FIELD

The present invention relates to a magnetic resonance device, a magnetic resonance system, a magnet device and a magnetic resonance method.

PRIOR ART

Nuclear magnetic resonance (NMR) is a technique that can provide structural information with remarkable detail. The scope of applications includes the study of the structure and dynamics of organic molecules and biomolecules in solution, as well as the study of solid materials such as crystalline proteins, carbon-based anodes, nitrogen-vacancy centers of diamonds, amorphous silica powder and many more. Electron paramagnetic resonance (EPR) works according to similar principles as NMR and provides information such as function and structure of radical enzymes, dynamics of proteins and in operandi studies of lithium ion batteries.

NMR resonance lines of static samples in the solid state are much broader than in solution due to anisotropic interactions experienced by the nuclei, critically degrading spectral resolution. Dominant contributions to linewidth in NMR originate from dipolar spin-spin couplings, chemical shift anisotropy and quadrupolar couplings in spin $I > 1/2$ systems. In solution, these anisotropic interactions are averaged out by rapid molecular motions. Anisotropic interactions also broaden the resonance lines of solids in EPR, with linewidths that are several orders of magnitude larger than typical solution-state linewidths in spin 1/2 systems in NMR.

Spinning the sample about a spinning axis of the sample at the magic angle $\Theta_m = $

$$\arctan \sqrt{2} \approx 54.74°$$ ("magic-angle spinning", MAS) partially averages the aforementioned anisotropic interactions. To spin a sample at the magic angle, the sample is packed into a cylindrical or spherical rotor, and the rotor is spun in the probe pneumatically. For cylinders, both drive and bearing gas are necessary for stable spinning, while one gas stream suffices for spheres.

Over the last decades, pneumatically driven MAS has become a standard technique for high resolution solid-state NMR. Since higher spinning frequencies result in sharper resonance lines, much effort has been spent to maximize the MAS frequency. MAS frequencies up to 170 kHz have been reported [Samoson2019].

Still higher frequencies would be needed to fully average $^1$H-$^1$H dipolar couplings or quadrupolar couplings in NMR or to sufficiently average anisotropic interactions in EPR. Higher spinning frequencies would also improve spin relaxation properties, which would enable better control over spins in NMR and EPR and would improve dynamic nuclear polarization (DNP), a technique which improves NMR sensitivity. Such gains in NMR and EPR performance could be employed, for instance, in the structural and motional characterization of molecular architectures of interest in biology and chemistry.

SUMMARY OF THE INVENTION

It is an object of the present invention to provide a magnetic resonance device that enables sample spinning at higher frequencies than hitherto possible.

This object is achieved by a magnetic resonance device according to claim 1. Further embodiments of the invention are laid down in the dependent claims.

In a first aspect, the present invention provides a magnetic resonance device comprising:

a sample spinning apparatus configured to spin a sample about a sample spinning axis, the sample spinning apparatus being configured to exert a torque on the sample by interaction of the sample with an electromagnetic sample spinning field; and a resonance structure for exposing the spinning sample to an electromagnetic excitation field to manipulate a nuclear or electronic spin state of the sample.

In to the present invention, electromagnetic energy is used to provide torque about the sample spinning axis for the spinning of samples in magnetic resonance experiments. With this invention, experiments can be performed in vacuum, or at low pressures, and the maximum spinning frequency will be limited only by the structural mechanical strength of the spinning object or the friction with the remaining gas molecules. MAS at spinning frequencies up to several gigahertz can in principle be achieved, enabling unprecedented spectral resolution in solid-state magnetic resonance spectroscopy. Also, spinning about two angles simultaneously (double angle spinning) can be implemented using the present invention by providing torque about a second axis.

In some embodiments, the sample spinning field comprises an oscillating electromagnetic field, in particular, a propagating or standing electromagnetic wave, that is circularly polarized so as to exert the torque on the sample by transfer of spin angular momentum from the electromagnetic field to mechanical angular momentum of the sample. In other embodiments, torque may be created by off-center irradiation of the sample with electromagnetic radiation, thus transferring linear momentum on the sample at a distance from the rotation axis by radiation pressure. Torque may also be created by a rotating electric field.

In some embodiments, the sample spinning field comprises light having a frequency above 30 THz, and the sample spinning apparatus comprises:

a laser for generating said light; and

a focusing element for focusing said light to the sample location;

optionally, a polarization control device for controlling a polarization state of the light.

In other embodiments, the sample spinning field comprises a microwave field having a frequency below 30 THz, and the sample spinning apparatus comprises:

a microwave source for generating microwave radiation; and

a microwave resonator coupled to the microwave source, wherein the sample location is positioned inside said microwave resonator.

The sample spinning apparatus may further be configured to confine ("trap") the sample at the sample location along one, two or three spatial directions by interaction of the sample with the sample spinning field and/or with an electromagnetic trapping field that is different from the sample spinning field. In some embodiments, the trapping field may comprise light having a frequency above 30 THz. Trapping and spinning of particles using light is known per se, and spinning frequencies of up to several GHz have been reported, see, e.g., [Monteiro2018], [Reimann2018] or [Jin2021]. In other embodiments, the trapping field may comprise a microwave field having a frequency below 30 THz. Trapping by microwaves has been described, e.g., in [Lewelling2018] and [Wright2019]. In yet other embodiments, electric fields may be used for confining the sample, as in a Paul trap.

The magnetic resonance device may further comprise a sample support structure configured to support the sample in addition to or in lieu of the electromagnetic trapping field. In some embodiments, the sample support structure may comprise one of the following structures:

- a transparent sample support plate configured to allow light to pass through the plate towards the sample, in particular, a diamond plate;
- a nozzle device for directing a fluid flow towards the sample, in particular, a flow of a gas or a flow of superfluidic helium.

For carrying out magnetic resonance experiments, the magnetic resonance device may further comprise an excitation apparatus coupled to the resonance structure to create the excitation field and/or a detection apparatus for detecting a response of the sample to the excitation field. The detection apparatus may comprise detection circuitry coupled to the resonance structure to detect a response of the sample to the excitation field through interaction of the sample with the resonance structure. In other embodiments, the detection apparatus may be configured to detect said response indirectly, e.g., optically, as it is known per se.

The resonance structure may be configured as a chip, comprising a flat carrier, in particular, a printed circuit board or a semiconductor chip, the carrier defining a carrier plane. If the sample spinning field comprises light, the carrier plane may be parallel to a direction of propagation of the light at the sample location, or the carrier plane may be transverse to the direction of propagation of the light at the sample location, the carrier having a hole to allow the light to pass through the carrier.

The magnetic resonance device may further comprise a vacuum chamber, and the sample location may be arranged inside the vacuum chamber to enable the sample to be spun in a vacuum.

By its design, the magnetic resonance device may be configured to expose the sample to a static magnetic field that defines a static field direction. In particular, the magnetic resonance device may be configured to be arranged relative to the static magnetic field in such a manner that the sample spinning axis has an orientation at the magic angle $\Theta_m = \arctan \sqrt{2}$ relative to the static field direction. In some embodiments, the magnetic resonance device may be configured to be inserted into a cylindrical bore of a superconducting magnet device such that the sample location is arranged inside the cylindrical bore. To this end, the magnetic resonance device may comprise a cylindrical probe body in which the sample location is arranged.

The present invention further provides a magnetic resonance system that actually comprises a magnet device for generating the static magnetic field along a static field direction.

In some embodiments, the sample spinning axis may be vertical or horizontal in space (i.e., parallel or perpendicular to the direction of gravity, i.e., the direction of the earth's gravitational field), and the static field direction is inclined to the sample spinning axis by the magic angle $\Theta_m$. In other embodiments, the static field direction is vertical or horizontal in space, and the sample spinning axis is inclined to the static field direction by the magic angle.

In another aspect, the present invention provides a magnet device that is configured to be used in conjunction with the magnetic resonance device of the present invention. The magnet device comprises a ring-shaped superconducting magnet having a ring axis that is inclined to the direction of gravity by the magic angle $\Theta_m = \arctan \sqrt{2}$. The superconducting magnet is configured to generate a static magnetic field having a static field direction that coincides with the ring axis.

In some embodiments, the magnet device comprises a disk-shaped magnet cryostat that defines a liquid helium bath in which the superconducting magnet is immersed, the disk-shaped magnet cryostat having a central bore along the ring axis, commonly called a "room-temperature bore", for providing access for the sample such that the sample can be exposed to the static magnetic field outside the liquid helium bath. The central bore is preferably configured such that a straight laser beam can be passed through the central bore at the magic angle to the ring axis, in particular, along the direction of gravity, without the beam intersecting the disk-shaped magnet cryostat. In particular, the central bore may be of cylindrical shape. It may have a diameter $D$ and a length $L$ along the ring axis, wherein the diameter $D$ and the length $L$ have a ratio $D/L > \sqrt{2}$.

In some embodiments, the magnet device further comprises:

an auxiliary cryostat that defines a liquid helium reservoir,
wherein the disk-shaped magnet cryostat is connected to the auxiliary cryostat in such a manner that liquid helium is able to flow between the liquid helium reservoir and the liquid-helium bath.

The auxiliary cryostat may further comprise a liquid nitrogen reservoir. The liquid nitrogen reservoir may at least partially surround the liquid helium reservoir to protect the auxiliary liquid helium reservoir from thermal radiation.

In advantageous embodiments, the disk-shaped magnet cryostat comprises a metallic radiation shield element comprising a shielding portion and a contact portion, the shielding portion being arranged in a vacuum between two shells of the disk-shaped magnet cryostat and at least partially surrounding the liquid-helium bath so as to protect the liquid helium bath from thermal radiation, and the contact portion being immersed in the liquid nitrogen reservoir of the auxiliary cryostat.

In another aspect, the present invention provides a magnetic resonance method comprising:

exposing a sample to a static magnetic field along a static field direction;
spinning the sample about a sample spinning axis, the sample spinning axis preferably having an orientation at the magic angle $\Theta_m = \arctan\sqrt{2}$ relative to the static field direction, torque about the sample spinning axis being exerted on the sample by interaction of the sample with an electromagnetic sample spinning field;
creating an excitation field to manipulate a spin state of the spinning sample; and measuring a response of the sample to the manipulation of the spin state.

Unlike in traditional MAS, where pressurized air is used to spin a rotor in which the sample is packed, no separate rotor is needed in the present invention, and the sample can be spun without being packed in a rotor. In particular, the sample may be a single particle, or it may comprise multiple particles that are individually rotated. However, the use of a rotor for packing the sample is not excluded. In some embodiments, the sample may be approximately spherical. The presently proposed method is particularly well suited for spinning samples having a diameter of not more than 1 mm. However, the method is not limited to such small samples, and sample size can reach 10 mm, 20 mm or even more.

BRIEF DESCRIPTION OF THE DRAWINGS

Preferred embodiments of the invention are described in the following with reference to the drawings, which are for the purpose of illustrating the present preferred embodiments of the invention and not for the purpose of limiting the same. In the drawings,

Fig. 1    shows a schematic functional diagram of a magnetic resonance system according to a first embodiment;

Fig. 2    shows a schematic central longitudinal sectional view through the magnet device of the magnetic resonance system in Fig. 1;

Fig. 3    shows a schematic functional diagram of a portion of a magnetic resonance system according to a variant of the first embodiment;

Fig. 4    shows a detail of Fig. 3 in the region E;

Fig. 5    shows a photograph of a miniaturized PCT on which a resonance structure is formed;

Fig. 6    shows a schematic functional diagram of a magnetic resonance system according to a second embodiment;

Fig. 7    shows a schematic functional diagram of a beam-splitting arrangement for use in the embodiment of Fig. 6;

Fig. 8    shows a schematic functional diagram of a magnetic resonance system according to a variant of the second embodiment;

Figs. 9-12    show schematic functional diagrams illustrating nozzle structures for directing a fluid flow at the sample;

Fig. 13    shows a schematic functional diagram of a sample on a sample support plate; and

Fig. 14    shows a schematic functional diagram of a magnetic resonance system according to a fourth embodiment.

DESCRIPTION OF PREFERRED EMBODIMENTS

Definitions

The term "magnetic resonance" encompasses nuclear magnetic resonance (NMR) and electron paramagnetic resonance (EPR), which is sometimes also called electron spin resonance (ESR).

The term "$B_0$ field" relates to a static magnetic field that causes a Zeeman splitting of nuclear and/or electronic spins in a sample. The direction of the $B_0$ field

is called the $z$ direction. In practice, the $B_0$ field is often created by a superconducting magnet in a cryostat.

The term "$B_1$ field" relates to an oscillating electromagnetic field that is able to change at least one spin state in the sample when the sample is exposed to the $B_0$ field. The $B_1$ field is normally applied at or near the Larmor frequency $\omega_L = \gamma B_0$ of the spin species whose spin state is to be modified, where $\gamma$ is the gyromagnetic ratio of the spin species.

The term "electromagnetic field" is to be understood broadly as encompassing static and time-dependent electric fields, static and time-dependent magnetic fields, and combinations thereof.

First embodiment: vertical spinning axis and inclined magnet device

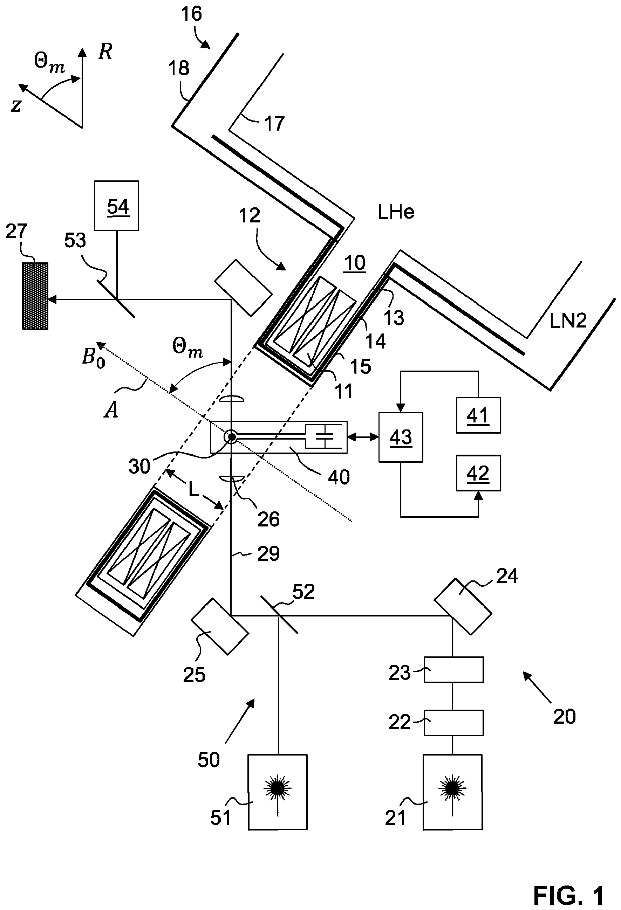

Figure 1 schematically illustrates a first embodiment of a magnetic resonance system that enables MAS using an electromagnetic field for sample spinning at the magic angle. It is to be understood that this Figure is not to scale.

The magnetic resonance system comprises a magnet device 10 comprising a ring-shaped (annular) superconducting magnet 11 having a ring axis A for creating a static magnetic field $B_0$ along a static field direction $z$. The ring-shaped superconducting magnet 11 is received in a flat, disk-shaped magnet cryostat 12 defining a cylindrical central room temperature bore along the ring axis of the magnet 11. The magnet cryostat 12 is connected to an auxiliary cryostat 16. Further details of the superconducting magnet 11, the magnet cryostat 12 and the auxiliary cryostat 16 will be provided below. The direction $z$ of the static magnetic field $B_0$ is inclined to the vertical direction in space, which is defined by the direction of gravity, by the magic angle $\Theta_m \approx 54.74°$.

A sample 30 in the form of a submillimeter-sized particle is trapped at a sample location inside the room temperature bore of the magnet device 10 by interaction of the sample 30 with an electromagnetic field in the form of a focused trapping laser beam. This kind of particle trap is known as a "single-beam gradient force trap" or more colloquially as "optical tweezers". Optical tweezers have been known for a long time, based on work by Arthur Ashkin and colleagues dating back to the 1970s. The focused laser beam provides a three-dimensional confining potential for the sample around the focus of the laser beam. The confining potential is able to counteract the force of gravity, thereby enabling levitation of the sample simply by its interaction with the laser beam. The confining potential additionally also leads to trapping in the horizontal plane perpendicular to the direction of gravity.

The sample 30 is located in the "sweet spot" of the magnet device 10, i.e., in the region of greatest homogeneity of the static magnetic field $B_0$. The sample 30 comprises at least one nuclear spin species, i.e., at least one species of nuclei with nonzero spin. By exposing the sample to the static magnetic field $B_0$, a Zeeman splitting is induced for these spins, causing a spin polarization.

A resonance structure 40 is arranged in the room-temperature bore of the magnet device 10 in immediate vicinity to the sample location. In the present embodiment, the resonance structure 40 comprises a flat carrier in the form of a printed circuit board (PCB). The PCB defines a carrier plane. The carrier plane is oriented vertically in space. Conductors are formed on the PCB, the conductors forming a printed excitation coil. Together with a capacitance, the excitation coil forms an LC resonance circuit. By providing radiofrequency (rf) power to the LC resonance circuit, an oscillating magnetic field (the so-called $B_1$ field) can be created in the vicinity of the excitation coil. The $B_1$ field is transverse to the direction $z$ of the static magnetic field $B_0$, i.e., it has a component that is perpendicular to the direction $z$. In Fig. 1, the direction of the $B_1$ field at the center of the excitation coil would be perpendicular to the drawing plane. By exposing the sample to the oscillating magnetic field $B_1$, the spin state of the spin species can be manipulated, as it is well known in the field of NMR.

The resonance circuit is connected to a duplexer 43, which in turn is connected to a transmitter 41 and a receiver 42. The transmitter 41 is configured to provide pulsed rf power to the resonance circuit to manipulate spin states of the nuclei in sample 30. The receiver 42 is configured to detect an electromotive force (EMF) that is induced in the resonance circuit due to a response of the nuclear spins to the rf pulses. The duplexer 43 ensures that the strong rf pulses from the transmitter 41 are directed to the resonance circuit while being blocked from the receiver 42, while the weak response signal received from the resonance circuit is directed to the receiver 42. The functionality of the duplexer may also be integrated into the resonance circuit, thus obviating the need of a separate duplexer.

Optical setup for first embodiment

The setup of the laser system of the first embodiment is adapted from [Monteiro2018]. In brief, a trapping laser beam 29 is created by a first laser 21 (the "trapping laser"). The trapping beam 29 is passed through an acousto-optic modulator (AOM) 22 for controlling beam power and through an electro-optic modulator (EOM) 23 for controlling the polarization of the beam. The trapping beam 29 is then reflected by a piezo-controlled mirror 24 for controlling the position of the beam. After passing through a first non-polarizing harmonic beam splitter 52, the trapping beam 29 is reflected upwards into a vertical direction opposite to the direction of gravity by a mirror 25. The exact direction of the trapping beam can be fine adjusted by adjusting the orientation of the mirror 25. The trapping beam 29 is focused to a diffraction limited focal spot at the sample location by a first aspherical lens 26 (e.g., having a focal length of 25 mm) and is re-collimated above the sample location by a second aspherical lens. The beam is then redirected towards a non-polarizing second harmonic beam splitter 54 and collected in a beam block 27.

A second laser beam, which acts as a diagnostic beam, is created by a second laser 51 (the "diagnostic laser"). The diagnostic beam has a different wavelength than the trapping beam and has fixed linear polarization. For instance, the trapping beam may have a wavelength of 1064 nm, and the diagnostic beam may have a wavelength of 532 nm. The diagnostic beam is coaligned with the trapping beam by the beam splitter 52 and passes through the sample location together with the trapping beam before being coupled out from the trapping beam by the beam splitter 53, from where it goes to a diagnostic sensor system 54. The diagnostic sensor system 54 may comprise a polarization-sensitive sensor (PSS) for detecting changes of the polarization state of the diagnostic beam by its interaction with the sample. Additionally, one or more lateral position sensors may be provided for determining lateral displacements of the sample from the nominal sample location. Reference is made to [Monteiro2018], where further details are provided.

The trapping beam 29 not only acts to trap the sample 30 at the sample location, but it also acts to spin the sample about a vertical sample spinning axis R by exerting a mechanical torque on the sample (in other words, by transferring angular momentum to the sample). To this end, the trapping beam is circularly polarized. By controlling the polarization direction (left handed vs. right handed) and the degree of polarization (ellipticity) of the trapping beam using the EOM 23, the spinning frequency of the sample 30 can be controlled.

For more details concerning the optical setup of the first embodiment and the mode of operation of the optical setup, reference is made to [Monteiro2018], the content of which is incorporated herein by reference in its entirety.

In practice, as the trapping laser 21, a 2 W "Mephisto" laser from Coherent may be used.

Suitable non-magnetic posts, mounts, mirrors, polarizing beam splitters, harmonic beam splitters, lenses and 2D lateral effect position sensors are commercially available, e.g., from Thorlabs. A position detection and feedback system in the form of a piezo-mirror, piezo-controller and position sensing detector is also commercially available from Thorlabs.

Construction of the magnet device for first embodiment

The disk-shaped magnet cryostat 12 defines a liquid helium (LHe) bath in which the superconducting magnet 11 is immersed. The LHe bath is defined by an inner shell 13. The inner shell 13 is surrounded by an outer shell 15. A vacuum is present between the inner shell 13 and the outer shell 15.

The auxiliary cryostat 16 likewise comprises an inner shell 18 and an outer shell 19. The inner shell 18 delimits a LHe reservoir that is fluidically connected with the LHe bath in the magnet cryostat 12. Between the inner shell 18 and the outer shell 19 of the auxiliary cryostat, a liquid nitrogen (LN2) reservoir is provided, surrounding the LHe reservoir as a thermal shield.

A shielding portion of a radiation shield element 14 is arranged in the vacuum between the inner shell 13 and outer shell 15 of the magnet cryostat 12. A flange-like contact portion of the radiation shield element 14 extends into the LN2 reservoir of the auxiliary cryostat 16. Thereby, the radiation shield element 14 is cooled to a temperature close to the LN2 temperature of 77 K. In this manner, efficient thermal shielding is achieved for the LHe bath of the magnet cryostat with minimal installation space. The radiation shield element 14 may, e.g., be made out of 2 mm thick Cu (or alternatively Al) due to its high thermal conductivity.

Both the magnet cryostat 12 and the auxiliary cryostat 16 may comprise additional insulation layers, in particular, made of so-called superinsulation materials, as it is well known in the art.

The superconducting magnet 11 may comprise two pancakes of a REBCO high-temperature superconducting (HTS) tape separated by a Cu disk, which is covered in insulating tape on one side to prevent pancake-to-pancake current jumps. Stainless steel tape is wound tightly around the respective double pancakes to keep them in place during operation. The ends of the stainless steel tape may be fixed to protruding stainless steel 316 (ss316) metal sheets.

Superconducting shim elements (not shown) inside the magnet cryostat 12 as well as room-temperature shim elements (not shown) in the bore of the magnet cryostat 12 may be provided for homogenizing the static magnetic field $B_0$ at the sample location, as it is well known in the field of NMR.

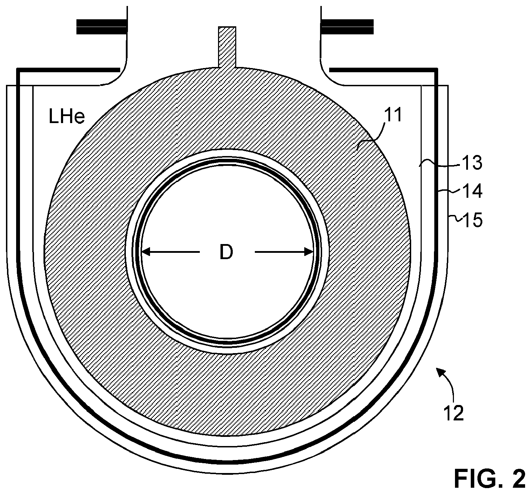

Fig. 2 schematically illustrates a sectional view through the magnet cryostat 12 in a sectional plane that is perpendicular to the ring axis A through one of the two pancakes of the superconducting magnet 11. The arrangement of the radiation shield element 14 between the inner shell 13 and the outer shell 15 is well visible in this view.

The magnet cryostat 12 is sufficiently flat to allow the trapping beam 29 to vertically pass through its room-temperature bore without hitting the magnet cryostat 12 when the magnet cryostat is inclined to the vertical direction by the magic angle, as in Fig. 1. In particular, the clear diameter $D$ of the room-temperature bore (see Fig. 2) is larger than its length $L$ (see Fig. 1), with $D/L > \sqrt{2}$.

The inner shell 13, the outer shell 15 and the radiation shield element 14 may be designed to be non-concentric at room temperature to account for differential thermal contraction of these elements when they are cooled to their respective operating temperatures, thus minimizing deformations due to thermal contraction during operation.

Variant of first embodiment: setup including vacuum chamber

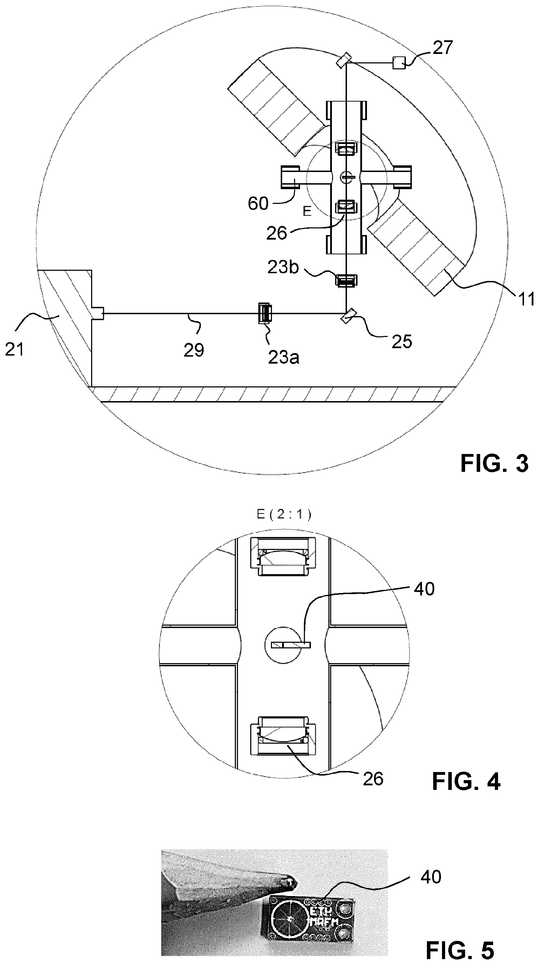

Figures 3 and 4 illustrate a variant of the first embodiment. The setup is similar to the setup in Fig. 1, with the following main differences: (a) a vacuum chamber 60 is provided in the room-temperature bore of the magnet device 10, encompassing the focusing optics (in particular, the aspherical lenses 26) and the sample , thereby enabling the sample to be levitated and rotated in a vacuum; (b) a different resonator structure 40 is provided, comprising a carrier whose carrier plane is perpendicular to the direction of propagation the trapping beam 29 rather than being parallel to the trapping beam; and (c) a combination of a half-wave plate 23a and a quarter-wave plate 23b is used to control polarization of the trapping beam. For simplicity, the diagnostic laser system has been omitted in Fig. 3.

The vacuum chamber 60 encompasses the focusing optics (in particular, the aspherical lenses) and the sample. It is made of a non-magnetic steel like ss316(L). The geometry of the chamber may be a 2-armed cube. Of course, different shapes for the vacuum chamber can be chosen according to need.

The resonator structure 40 used in this variant is shown in Figure 5 side by side with the tip of a pencil as an indication of size. Like in the first embodiment, the resonator structure of Fig. 5 comprises a PCB on which conductors are disposed to form a printed excitation coil. A hole is provided in the PCB at the center of the excitation coil to allow the trapping beam to pass through the resonator structure unhindered.

Second embodiment: Trapping and sample spinning inside a vertical bore

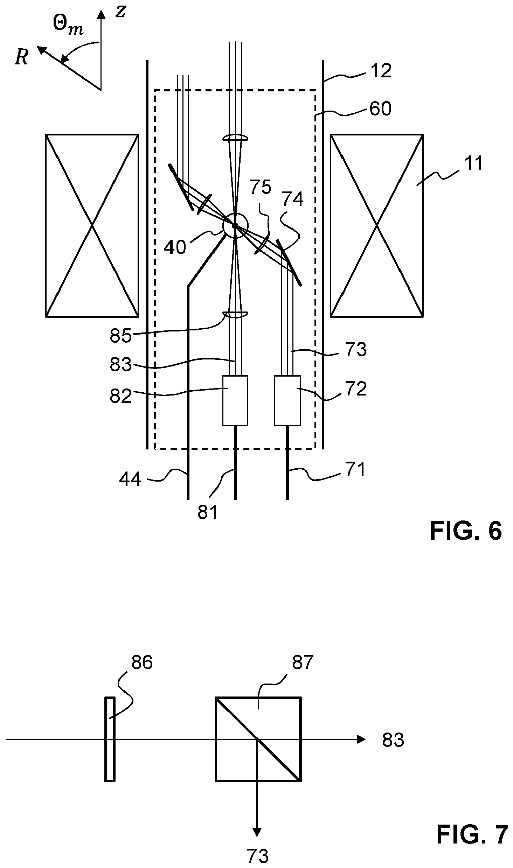

Figure 6 illustrates a second embodiment of a magnetic resonance system. In this embodiment, the magnet device is a normal vertically oriented NMR magnet device, as it is commonly used for solution NMR or solid-state NMR. The magnet device comprises a vertically oriented, annular superconducting magnet 11 for creating a static magnetic field $B_0$ along the vertical direction. The superconducting magnet 11 is received in a magnet cryostat 12 that defines a vertical room temperature bore. The room temperature bore may have any of the standard diameters that are commonly used in NMR, e.g., 89 mm ("wide bore") or 52 mm ("standard bore"), or it may have any other, non-standard diameter, including yet smaller diameters such as 25 mm.

A vacuum chamber 60 is arranged in the bore of the magnet cryostat 12. A sample is trapped inside a vacuum chamber 60 by a vertical trapping beam 83, which propagates antiparallel to the direction of gravity and is focused to a diffraction-limited focal point by an aspherical lens 85 to create a three-dimensional trapping potential for the sample, similar to the first and second embodiments. The trapping beam 83 is coupled into the vacuum chamber 60 by an optical fiber 81 and is collimated to form a collimated beam in vacuum by a collimator 82.

Torque is exerted onto the sample by a separate sample spinning beam 73. At the sample location, the sample spinning beam 73 is oriented at the magic angle $\Theta_m$ relative to the static magnetic field direction $z$. To this end, the sample spinning beam 73 is reflected into the magic angle by a tilted mirror 74. The exact angle of the sample spinning beam 73 can be adjusted by adjusting the tilt angle of the mirror 74. The sample spinning beam is focused to the sample location by an aspherical lens 75. Like the trapping beam, also the sample spinning beam 73 is coupled into the vacuum chamber 60 by an optical fiber 71 and is collimated by a collimator 72. Instead of using the tilted mirror 74, a bent optical fiber may be used to directly provide the sample spinning beam 73 at the magic angle.

As in the first and second embodiments, a resonator structure 40 (shown only symbolically in Fig. 6 as a circle) is arranged near the sample location to manipulate the spins in the sample and to detect a response of the spins.

As illustrated in Fig. 7, the sample spinning beam 73 and the trapping beam 83 may be created from a single, linearly polarized laser beam using a half-wave plate 86 and a polarizing beam splitter 87, enabling precise control over the polarization and power of each of the two beams 73 and 83.

Variant of second embodiment: Trapping and sample spinning inside a vertical bore magnet using a single laser beam

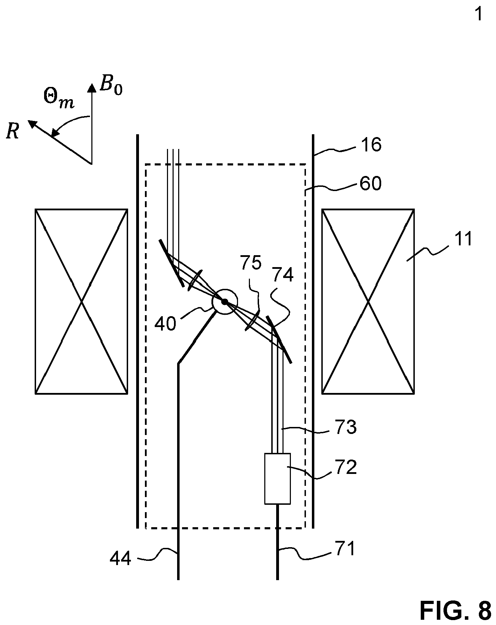

Figure 8 illustrates a variant of the second embodiment. Again, the magnet device is a normal "wide-bore" NMR magnet device, as it is commonly used for solid-state NMR, and a vacuum chamber 60 is arranged in the room temperature bore of the magnet device. In contrast to the embodiment of Fig. 6, both sample trapping and sample spinning are achieved by a single laser beam 73 that is inclined at the magic angle $\Theta_m$ relative to the vertical direction. The laser beam 73 thus acts as both the sample trapping beam and the sample spinning beam.

Sample

The sample may be brought to the sample location by suspending it in aqueous solution and spraying the suspension towards the sample location with a nebulizer. In other embodiments, the sample may be positioned below the sample location on a sample support plate, e.g., a glass slide, and the sample support plate may be vibrated to make the sample "jump" into the sample location, where it is trapped. This works particularly well for larger sample particles. Trapping in liquids can be achieved by placing a thin glass container filled with the sample suspension at the sample location.

There are multiple options concerning the choice of sample. For instance, polymer particles, NV center diamonds or silica particles may be used. The most crucial aspects to consider are (i) the stability of the sample during sample spinning; (ii) sample heating due to interaction of the sample with the electromagnetic field; and (iii) the number of EPR- or NMR-active spins that can be detected.

To date, the most stable trapping in vacuum has been achieved with silica spheres. Due to the limitations on NMR sensitivity, the spheres should be as large as possible. For instance, for a fully enriched $^{29}SiO_2$ sphere with 100 $\mu$m diameter, a conventional NMR setup suffices to detect the nuclear spins.

Dynamic nuclear polarization (DNP) may be employed to enhance sensitivity. For instance, a silica sphere can be $\gamma$-irradiated, producing radical defects that can be used for cross polarization from electrons to $^{29}Si$.

As another example, polystyrene spheres may be used. Polystyrene comprises more than $10^{14}$ spins of $^1H$ (and $^{13}C$ if enriched) in a 30 $\mu$m sphere, readily allowing for direct detection on $^1H$. Detection on $^1H$ provides fast recovery time and a large gyromagnetic ratio. Neglecting cross polarization and recovery time, detecting on $^1H$ is 32 times more sensitive as compared to $^{13}C$ and 57 times more sensitive compared to $^{29}Si$.

NV centers have been levitated in air successfully and provide a slightly higher amount of NMR-active nuclei than silica spheres for identical size. They are of considerable interest due to their potential as qubits and are being researched actively. DNP can be used to improve sensitivity. NV centers may also be investigated by EPR.

Pure nanodiamonds with 1000 times greater purity than NV centers have been levitated at low pressures without heating due to their low absorption at 1064 nm. For details see [Hoang2016]. Active center-of-mass feedback control may be used to stabilize the lateral positions of the nanodiamonds.

Vaterite has been levitated and rotated with similar conditions to silica and can be synthesized from reasonably cheap starting materials, which are available $^{13}C$ enriched.

Since rotation of the sample averages out anisotropic interaction to first order, quadrupolar nuclei may be an attractive species to demonstrate how the NMR linewidth changes depending on the polarization of light. Ruby or $Al_2O_3$ spheres are one option, since $^{27}Al$ is a 100% abundant spin 5/2 system with a similar gyromagnetic ratio as $^{13}C$.

Ruby is also an interesting system for studying directly detected or optically detected EPR of a rotating sample due to the presence of $Cr^{3+}$ impurities.

Borosilicate glass is about 90% transparent to 1064 nm and contains spin-3 $^{10}B$ and spin-3/2 $^{11}B$ nuclei, which may be detected directly or indirectly via dipolar coupling on the silicon atoms. Furthermore, $\gamma$-irradiation allows access to DNP methods.

If sample stability in vacuum is an issue, rotation in liquids is an alternative. For instance, gold nanorods have been proven to rotate at high frequencies (42 kHz in a colloidal suspension).

Sample support structures

In some cases, it may not be possible to levitate the sample by the action of an electromagnetic field (e.g., by a laser beam) alone. In such cases, it may be required to add a sample support structure for aiding with support of the sample against the force of gravity.

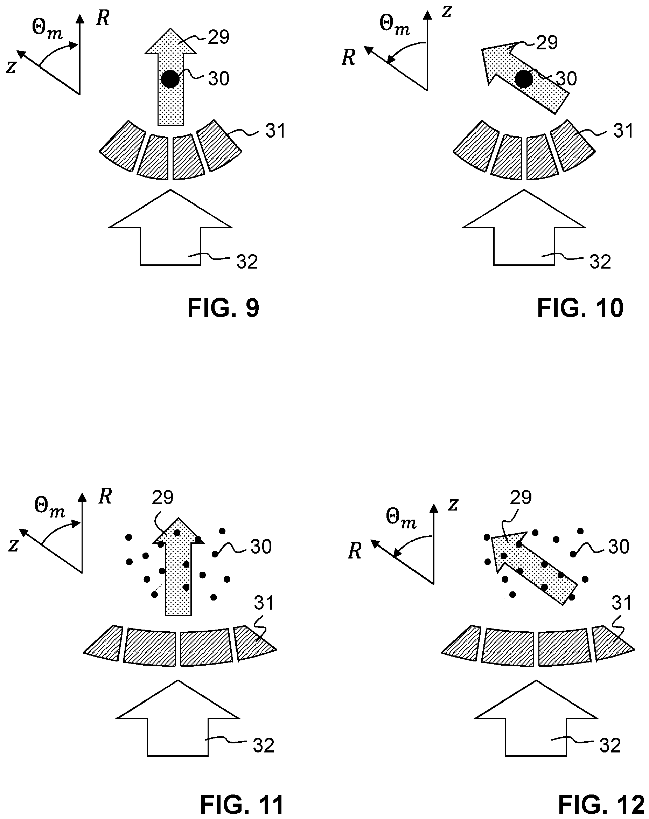

Figures 9 to 12 illustrate, in a schematic manner, various examples of sample support structures. In Figs. 9-11, the sample support structure comprises a cup-shaped nozzle structure 31 for directing a fluid flow 32 towards the sample 30. The fluid may be, e.g., a low-pressure gas or a superfluid like superfluidic $^3He$. The flow causes an upwardly directed drag force on the sample 30, which counteracts the gravitational force and thus aids with stably levitating the sample. In the example of Fig. 9, the sample spinning beam 29 is oriented vertically, and the static field direction $z$ of the static magnetic field $B_0$ is oriented at the magic angle relative to the vertical direction, as in the first embodiment. In the example of Fig. 10, static magnetic field $B_0$ is oriented vertically, and the sample spinning beam 29 is oriented at the magic angle relative to the vertical direction, as in the second embodiment. Instead of levitating only one single particle, it is also possible to simultaneously levitate multiple particles, as illustrated in Figs. 11 and 12, i.e., the sample may comprise more than one single particle.

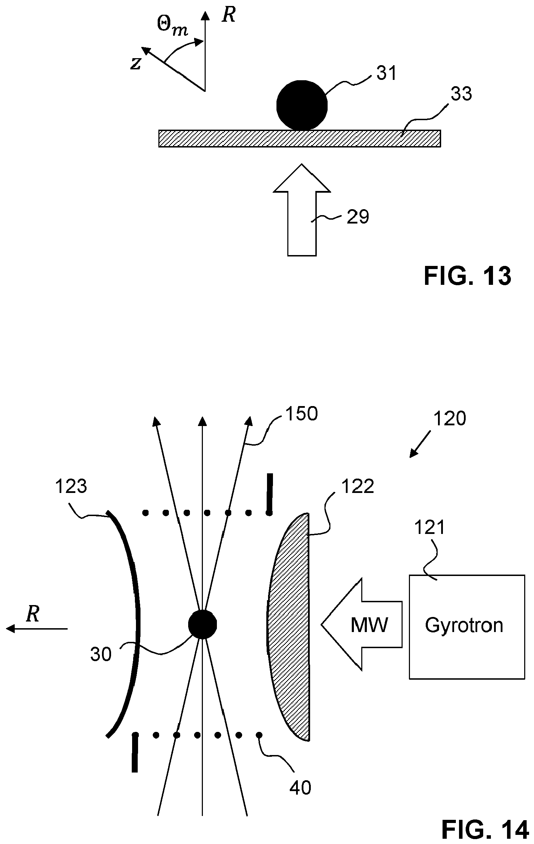

Fig. 13 illustrates a sample support structure in the form of a transparent sample support plate 33. The sample spinning beam 29 is able to pass through the sample support plate 33 in order to transfer torque onto the sample about the vertical direction. The sample support plate 33 is preferably made of a low friction material like diamond. A sphere, which may be made of diamond as well, can be caused to spin on such a sample support plate with extremely low friction, since the area of contact between the sample support plate and the spherical sample is extremely small, essentially being a single point of contact. Sample spinning takes place about a sample spinning axis that is parallel to a surface normal of the sample support plate 30. Thereby, the absolute velocity of the small surface portion of the sample that is in contact with the sample support plate 30 is very small, which further reduces frictional forces.

Microwave resonator structure

Figure 14 illustrates, in a highly schematic manner, an arrangement wherein the sample is caused to spin by a microwave field. Microwaves are generated by a microwave source 121, e.g., a gyrotron, and transmitted to a Fabry-Perot resonator comprising an at least partially microwave-transparent entrance lens 122 (e.g., made of PTFE) and a reflecting mirror 123. A standing wave pattern develops inside the resonator. For instance, for 198 GHz microwave radiation, the entrance lens 122 and the reflecting mirror 123 may have a minimal distance of approximately 0.75 mm, which corresponds to half the wavelength of the microwave radiation. The sample 30 may not only be rotated inside the resonator by the microwave field, but it may also be trapped by the microwave field. Trapping may be supported by a focused laser beam 150. A solenoid coil 40 may be provided for feeding rf energy to the sample in order to manipulate nuclear spins in the sample and/or to detect a response of the nuclear spins to their manipulation.

In alternative embodiments, the sample 30 is both trapped and rotated by the laser beam 150, and the resonator is used for exciting and/or detecting EPR.

Modifications

Many modifications of the arrangements of the sample spinning axis and the static magnetic field direction in space are possible. In particular, it is possible to spin the sample about a horizontal spinning axis, and to arrange the static magnetic field at the magic angle relative to the horizontal spinning axis. The presently proposed method of sample spinning is not only useful for spinning the sample at the magic angle. It is possible to spin the sample at other angles relative to the static field direction as well.

Instead of spinning (and possibly trapping) the sample using circularly polarized laser light in the UV, VIS or IR regions or using a microwave field, it is also possible to spin (and possibly trap) the sample using time-varying electric fields, as in a Paul trap. For instance, the electrical field on poles within a stator could be set to oscillate at the spinning frequency to provide torque. Torque could also be created by linear momentum transfer from photons that hit the spinning sample off-center to result in translational to angular momentum transfer.

It is also possible to use different kinds of electromagnetic fields for trapping and spinning. For instance, a Paul trap may be used for trapping the sample, while circularly polarized light may be used for applying torque to the sample. With this combination, comparatively large particles may be trapped and spun, the particle diameter even exceeding 1 mm.

It is also possible to first spin the sample by a known mechanical spinning method, e.g., by the action of a fluid, and use the electromagnetic sample spinning field only to further accelerate and/or maintain the thus-induced spinning motion of the sample.

The presently proposed method of sample spinning may be combined with any known method of polarization enhancement in EPR and NMR, in particular, with optically pumped EPR or NMR or dynamic nuclear polarization (DNP) methods. Such methods are well established.

The presently proposed method of sample spinning may also be combined with any known method of spin manipulation in EPR and NMR, in particular, with multiple-pulse methods, cross-polarization, homo- and heteronuclear decoupling etc. Many such methods have been developed over the decades.

Finally, the presently proposed method of sample spinning may be combined with any known detection method for detecting a response of the spins in the sample to the spin manipulation, in particular, detection of an EMF induced in an inductor, changes of resonant properties of a resonator, and optical detection.

The resonance structure for manipulating the spin state of the sample (and optionally for detecting its response) may have any known design that does not interfere with the sample spinning field. In particular, instead of using a printed coil on a carrier like a PCB or semiconductor chip, a traditional solenoid microcoil or Helmholtz microcoil may be used. The microcoil may be designed with a gap to allow a laser beam to pass through the gap unhindered.

References

[Samoson2019] A. Samoson, "H-MAS", J. Magn. Reson. 306 (2019), 167-172, DOI: 10.1016/j.jmr.2019.07.010

[Hoang2016] Thai M. Hoang et al., "Electron spin control of optically levitated nanodiamonds in vacuum", Nature Comm. 7:12250 (2016), DOI: 10.1038/ncomms12250

[Reimann2018] R. Reimann et al, "GHz Rotation of an Optically Trapped Nanoparticle in Vacuum", Phys. Rev. Lett. 121, 033602 (2018), DOI: 10.1103/PhysRevLett.121.033602

[Monteiro2018] F. Monteiro et al., "Optical rotation of levitated spheres in high vacuum", Phys. Rev. A 97, 051802(R) 2018, DOI:10.1103/PhysRevA.97.051802

[Jin2021] Yuanbin Jin et al., "6 GHz hyperfast rotation of an optically levitated nanoparticle in vacuum", Photonics Research, 9(7) 2021, 1344, DOI: 10.1364/PRJ.422975

[Lewelling2018] C. Lewelling, "Electromagnetic Simulations of Microwave Trapping Structures", Bachelor of Science Thesis, William and Mary, 2018

[Wright2019] S. C. Wright et al., "Microwave trap for atoms and molecules", Phys. Rev. Research 1, 033035 (2019)

## Claims

1. A magnetic resonance device comprising:

   a sample spinning apparatus (20) configured to spin a sample (30) about a sample spinning axis (R); and
   a resonance structure (40) for exposing the spinning sample (30) to an electromagnetic excitation field ($B_1$) to manipulate a nuclear or electronic spin state of the sample (30), **characterized in that** the sample spinning apparatus (20) is configured to exert a torque on the sample (30) by interaction of the sample (30) with an electromagnetic sample spinning field.

2. The magnetic resonance device of claim 1, wherein the sample spinning field comprises an oscillating electromagnetic field that is circularly polarized so as to exert the torque on the sample (30) by transfer of angular momentum from the electromagnetic field to the sample (30).

3. The magnetic resonance device of claim 2, wherein the sample spinning field comprises light, and wherein the sample spinning apparatus comprises:

   a laser (21) for generating said light; and
   a focusing element (26) for focusing said light to the sample location; and
   optionally, a polarization control device (24) for controlling a polarization state of the light.

4. The magnetic resonance device of claim 2 or 3, wherein the sample spinning field comprises a microwave field, and wherein the sample spinning apparatus comprises:

   a microwave source (121) for generating microwave radiation; and
   a microwave resonator (122, 123) coupled to the microwave source (121), wherein the sample location is positioned inside said microwave resonator (122, 123).

5. The magnetic resonance device of any one of the preceding claims, wherein the sample spinning apparatus (20) is further configured to confine the sample at the sample location by interaction of the sample with the sample spinning field and/or with an electromagnetic trapping field that is different from the sample spinning field, in particular, wherein the trapping field comprises light or a microwave field.

6. The magnetic resonance device of any one of the preceding claims, further comprising a sample support structure configured to support the sample (30), in particular, one of the following structures:

   - a transparent sample support plate (33) configured to allow light to pass through the plate towards the sample (30), in particular, a diamond plate;
   - a nozzle device (31) for directing a fluid flow (32) towards the sample (30), in particular, a flow of a gas or a flow of superfluidic helium.

7. The magnetic resonance device of any one of the preceding claims, further comprising a vacuum chamber (60), wherein the sample location is arranged inside the vacuum chamber (60) to enable the sample (30) to be spun in a vacuum.

8. The magnetic resonance device of any one of the preceding claims, further comprising:

   an excitation apparatus (41) coupled to the resonance structure (40) to create the excitation field ($B_1$); and/or
   a detection apparatus (42) for detecting a response of the sample (30) to the excitation field ($B_1$), in particular, detection circuitry coupled to the resonance structure to detect a response of the sample to the excitation field ($B_1$) through interaction of the sample with the resonance structure.

9. The magnetic resonance device of any one of the preceding claims, wherein the resonance structure (40) comprises a flat carrier, in particular, a printed circuit board or a semiconductor chip, the carrier defining a carrier plane;
   in particular, wherein the magnetic resonance device is configured according to claim 3, and wherein either the carrier plane is parallel to a direction of propagation of the light at the sample location, or wherein the carrier plane is transverse to the direction of propagation of the light at the sample location, the carrier having a hole to allow the light to pass through the carrier.

10. The magnetic resonance device of any one of the preceding claims, wherein the magnetic resonance device is configured to expose the sample to a static magnetic field ($B_0$) that defines a static field direction ($z$),

    in particular, wherein the magnetic resonance device is configured to be arranged relative to the static magnetic field ($B_0$) in such a manner that the sample spinning axis (R) has an orientation at the magic angle $\Theta_m = \arctan \sqrt{2}$ relative to the static field direction ($z$),

in particular, wherein the magnetic resonance device is configured to be inserted into a cylindrical bore (16) of a superconducting magnet device such that the sample location is arranged inside the cylindrical bore (16).

11. A magnetic resonance system, comprising:

a magnet device (10) for generating a static magnetic field ($B_0$) along a static field direction (z), and
the magnetic resonance device of any one of the preceding claims,
in particular, wherein the magnetic resonance device is arranged relative to the static magnetic field ($B_0$) in such a manner that the sample spinning axis (R) has an orientation at the magic angle $\Theta_m = \arctan \sqrt{2}$ relative to the static field direction (z), more particularly, wherein the sample spinning axis (R) is parallel or perpendicular to a direction of gravity, and wherein the static field direction (z) is inclined to the sample spinning axis (R) by the magic angle $\Theta_m$.

12. A magnet device comprising a ring-shaped superconducting magnet (11) having a ring axis (A) that is inclined to a direction of gravity by the magic angle $\Theta_m = \arctan \sqrt{2}$, the superconducting magnet (11) being configured to generate a static magnetic field ($B_0$) having a static field direction (z) along the ring axis (A).

13. The magnet device of claim 12, further comprising:

a disk-shaped magnet cryostat (12) that defines a liquid helium bath in which the superconducting magnet (11) is immersed, the disk-shaped magnet cryostat (12) having a central bore along the ring axis (A), the central bore preferably having a clear diameter $D$ and a length $L$ along the ring axis with a ratio $D/L > \sqrt{2}$;
wherein the magnet device preferably further comprises an auxiliary cryostat (16) that defines a liquid helium reservoir, wherein the disk-shaped magnet cryostat (12) is connected to the auxiliary cryostat (16) in such a manner that liquid helium is able to flow between the liquid helium reservoir and the liquid-helium bath,
wherein preferably the auxiliary cryostat (16) comprises a liquid nitrogen reservoir and wherein the disk-shaped magnet cryostat (12) preferably comprises a metallic radiation shield element (14) comprising a shielding portion and a contact portion, the shielding portion being arranged in a vacuum between two shells (13, 15) of the disk-shaped magnet cryostat (12) and at least partially surrounding the liquid-helium bath so as to protect the liquid helium bath from thermal radiation, and the contact portion being immersed in the liquid nitrogen reservoir of the auxiliary cryostat (16).

14. A magnetic resonance method, comprising:

exposing a sample (30) to a static magnetic field ($B_0$) along a static field direction (z);
spinning the sample (30) about a sample spinning axis (R), the sample spinning axis (R) preferably having an orientation at the magic angle $\Theta_m = \arctan \sqrt{2}$ relative to the static field direction (z);
creating an excitation field ($B_1$) to manipulate a spin state of the spinning sample (30); and
measuring a response of the sample (30) to the manipulation of the spin state,
**characterized in that** torque is exerted on the sample (30) by interaction of the sample (30) with an electromagnetic sample spinning field.

15. The magnetic resonance method of claim 14, wherein the sample (30) comprises one or more particles that are not packed in a rotor.

**FIG. 1**

LHe

D

11

13
14
15

12

**FIG. 2**

**FIG. 3**

E ( 2 : 1 )

**FIG. 4**

**FIG. 5**

FIG. 6

FIG. 7

FIG. 8

**FIG. 9**

**FIG. 10**

**FIG. 11**

**FIG. 12**

**FIG. 13**

**FIG. 14**

Europäisches
Patentamt

European
Patent Office

Office européen
des brevets

## EUROPEAN SEARCH REPORT

**Application Number**

EP 22 15 1713

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/181275 A1 (BARNES ALEXANDER [US]) 17 June 2021 (2021-06-17) <br> * figures 8A,9A,13 * <br> * paragraph [0108] – paragraph [0165] * | 1-11,14, 15 | INV. <br> G01R33/30 <br> G01R33/60 <br> G21K1/00 <br> G01R33/38 |
| A | KAMPMANN R. ET AL: "Optical tweezers for trapping in a microfluidic environment", APPLIED OPTICS, <br> vol. 57, no. 20, 10 July 2018 (2018-07-10) , page 5733, XP055929436, <br> US <br> ISSN: 1559-128X, DOI: 10.1364/AO.57.005733 <br> * section "2. DESIGN APPROACH AND ENVIRONMENT" * | 1-11,14, 15 | G01R33/3815 <br> H01F6/00 <br> H01F6/04 |
| A | YUANBIN JIN ET AL: "6 GHz hyperfast rotation of an optically levitated nanoparticle in vacuum", ARXIV.ORG, CORNELL UNIVERSITY LIBRARY, 201 OLIN LIBRARY CORNELL UNIVERSITY ITHACA, NY 14853, <br> 25 April 2021 (2021-04-25), XP081927884, <br> * section "II. TRAP NANOPARTICLE FROM ATMOSPHERIC TO LOW PRESSURE WITHOUT USING FEEDBACK COOLING" * | 1-11,14, 15 | |
| X | CN 111 685 762 A (XINGAOYI MEDICAL EQUIPMENT CO LTD) 22 September 2020 (2020-09-22) <br> * figures 1,2 * <br> * paragraph [0037] – paragraph [0045] * | 12,13 | |
| X | GB 2 525 209 A (IMP INNOVATIONS LTD [GB]) 21 October 2015 (2015-10-21) <br> * figures 2,3A,3B * <br> * page 1 – page 2 * <br> * page 17, line 7 – line 13 * <br> * page 7 – page 9 * | 12,13 | |

**TECHNICAL FIELDS SEARCHED (IPC)**

G01R
H05G
G21K
H01F

The present search report has been drawn up for all claims

| Place of search | Date of completion of the search | Examiner |
|---|---|---|
| Munich | 22 July 2022 | Durst, Markus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

................................................................
& : member of the same patent family, corresponding document

EPO FORM 1503 03.82 (P04C01)

Europäisches
Patentamt

European
Patent Office

Office européen
des brevets

Application Number

EP 22 15 1713

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

**see sheet B**

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

**Europäisches Patentamt**
**European Patent Office**
**Office européen des brevets**

## LACK OF UNITY OF INVENTION
## SHEET B

Application Number

EP 22 15 1713

The Search Division considers that the present European patent application does not comply with the requirements of unity of invention and relates to several inventions or groups of inventions, namely:

    1. claims: 1-11, 14, 15

        device and method for spinning a sample with an
        electromagnetic field
                        ---

    2. claims: 12, 13

        a magnet device comprising a superconducting magnet
                        ---

## ANNEX TO THE EUROPEAN SEARCH REPORT
## ON EUROPEAN PATENT APPLICATION NO.

EP 22 15 1713

This annex lists the patent family members relating to the patent documents cited in the above-mentioned European search report.
The members are as contained in the European Patent Office EDP file on
The European Patent Office is in no way liable for these particulars which are merely given for the purpose of information.

22-07-2022

| Patent document cited in search report | | Publication date | Patent family member(s) | | Publication date |
|---|---|---|---|---|---|
| US 2021181275 | A1 | 17-06-2021 | EP 3717924 A1 | | 07-10-2020 |
| | | | US 2021181275 A1 | | 17-06-2021 |
| | | | WO 2019108754 A1 | | 06-06-2019 |
| CN 111685762 | A | 22-09-2020 | NONE | | |
| GB 2525209 | A | 21-10-2015 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **A. SAMOSON.** H-MAS. *J. Magn. Reson.,* 2019, vol. 306, 167-172
- **THAI M. HOANG et al.** Electron spin control of optically levitated nanodiamonds in vacuum. *Nature Comm,* 2016, vol. 7, 12250
- **R. REIMANN et al.** GHz Rotation of an Optically Trapped Nanoparticle in Vacuum. *Phys. Rev. Lett.,* 2018, vol. 121, 033602
- **F. MONTEIRO et al.** Optical rotation of levitated spheres in high vacuum. *Phys. Rev. A,* 2018, vol. 97, 051802
- **YUANBIN JIN et al.** 6 GHz hyperfast rotation of an optically levitated nanoparticle in vacuum. *Photonics Research,* 2021, vol. 9 (7), 1344
- Electromagnetic Simulations of Microwave Trapping Structures. **C. LEWELLING.** Bachelor of Science Thesis. William and Mary, 2018
- **S. C. WRIGHT et al.** Microwave trap for atoms and molecules. *Phys. Rev. Research,* 2019, vol. 1, 033035